# EUROPÄISCHE PATENTSCHRIFT

(11) **EP 2 220 668 B1**
(45) Veröffentlichungstag und Bekanntmachung des Hinweises auf die Patenterteilung: **12.10.2011**
(21) Anmeldenummer: 08860775.9
(22) Anmeldetag: 10.12.2008
(51) Int. Cl.: H01L 21/04, H01L 21/00

(54) **VERFAHREN UND ANORDNUNG ZUM TEMPERN VON SIC-WAFERN**
METHOD AND ARRANGEMENT FOR TEMPERING SIC WAFERS
PROCÉDÉ ET DISPOSITIF DE MALLÉABILISATION DE TRANCHES EN SIC

(30) Priorität: 11.12.2007 DE 102007059814
(43) Veröffentlichungstag der Anmeldung: 25.08.2010
(73) Patentinhaber: Centrotherm Thermal Solutions GmbH + CO. KG, 89143 Blaubeuren (DE)
(72) Erfinder: UWE, Keim, 72582 Grabenstetten (DE); HARTUNG, Robert Michael, 89143 Blaubeuren (DE)
(74) Vertreter: Wagner, Karl H.
(86) Internationale Anmeldenummer: PCT/EP2008/067197
(87) Internationale Veröffentlichungsnummer: WO 2009/074601

(56) Entgegenhaltungen:
- DE-A1- 19 633 183
- US-A- 5 981 900
- FUJIHIRA K ET AL: "SPECULAR SURFACE MORPHOLOGY OF ALUMINUM-IMPLATED 4H-SIC(0001) BY SIH4-ADDED AR ANNEAL" JAPANESE JOURNAL OF APPLIED PHYSICS, JAPAN SOCIETY OF APPLIED PHYSICS, TOKYO,JP, Bd. 43, Nr. 1, 1. Januar 2004 (2004-01-01), Seite 115/116, XP001191466 ISSN: 0021-4922

## Beschreibung

Die Erfindung betrifft ein Verfahren sowie eine Anordnung zum Tempern von SiC-Wafern.

Siliziumcarbid-Wafer (SiC-Wafer) bzw. Siliziumscheiben, müssen nach dem Implantieren mit Fremdatomen (z.B. mit A1, P, B) einem Temperprozess, auch als Annealing bzw. Ausheilen bezeichnet, unterzogen werden, um die implantierten Fremdatome in das SiC Kristallgitter einzubinden und sie damit elektrisch leitfähig zu machen. Der Schaden, welcher durch das Implantieren von Fremdatomen in ein Kristallgitter zwangsläufig entsteht, kann während dieses Temperprozesses nur teilweise "geheilt" werden. Dieser Prozess findet gewöhnlich in einem Hochtemperaturprozess bei Temperaturen zwischen 1600 - 2000 °C im Prozessraum eines Temperofens für einzelne SiC-Wafer, oder eine Vielzahl von SiC-Wafern gleichzeitig, statt.

Bei diesen Temperaturen entsteht jedoch das Problem, dass erste Atomlagen von Silizium aus dem Kristallgitter der Siliziumkarbidschicht (SiC) abgetragen werden, wodurch die an sich glatte SiC-Oberfläche beschädigt wird, oder es findet ein "Step bunching" statt, d.h. es erfolgt ein Verschieben von Kristallstrukturen innerhalb des Wafers.

Um hier Abhilfe zu schaffen, besteht die Möglichkeit, während des Hochtemperaturprozesses Silan in den Prozessraum einzulassen, wodurch eine Erhöhung des Silizium-Partialdrucks erreicht werden kann. Üblich ist die Verwendung eines Silan-Inertgasgemisches, wobei als Inertgas Argon verwendet wird, wie in FUJIHIRA K ET AL: "SPECULAR SURFACE MORPHOLOGY OF ALUMINUM-IMPLATED 4H-SIC(0001) BY SIH4-ADDED AR ANNEAL" JAPANESE JOURNAL OF APPLIED PHYSICS, JAPAN SOCIETY OF APPLIED PHYSICS, TOKYO,JP, Bd. 43, Nr. 1, 1. Januar 2004 (2004-01-01), Seite 115/116, ISSN: 0021-4922 beschrieben.

Silan (SiH₄) ist allerdings wegen seiner Neigung zur Selbstentzündung äußerst gefährlich und daher schwierig und aufwändig zu handhaben.

Aus der DE 196 33 183 A1 ist ein Verfahren zur Herstellung eines Halbleiterbauelements bekannt, bei dem das Halbleiterbauelement für einen Ausheilprozess in einen Behälter gelegt und im Verlauf des Ausheilprozesses zusätzlich ein siliziumhaltiges Material in den Behälter eingebracht wird.

Der Erfindung liegt daher die Aufgabe zugrunde, ein Verfahren und eine Anordnung zum Tempern von SiC-Wafern zur Erzeugung eines ausreichenden Si-Partialdrucks im Prozessraum und unter Verringerung der Betriebskosten zu schaffen.

Erfindungsgemäß wird diese Aufgabe durch ein Verfahren nach Anspruch 1 und eine Anordnung gemäß Anspruch 7 gelöst. Weitere Ausgestaltungen der Erfindung ergeben sich aus den jeweiligen Unteransprüchen.

Insbesondere wird bei dem Verfahren eine Vielzahl von SiC-Wafern in einen Prozessraum eines Temperofens eingebracht und ein Vakuum im Prozessraum erzeugt. Die SiC-Wafer werden gleichzeitig auf eine Prozesstemperatur von 1600 - 2000 °C erhitzt, und der Si-Partialdrucks in der Atmosphäre des Prozessraumes auf einen Wert über dem Dampfdruck des im SiC-Wafer gebundenen Siliziums über einen vorgegebenen Zeitraum bei gleich bleibender Prozesstemperatur erhöht, wobei ein Gemisch aus einem Trägergas und gas- oder dampfförmigem Silizium in den Prozessraum eingeleitet wird. Als Trägergase kommen Argon, Helium oder auch H₂ in Betracht.

Im Interesse einer gleich bleibenden Prozesstemperatur wird das gas- oder dampfförmige Silizium oder das Gemisch aus dem Trägergas und dem gas- oder dampfförmigen Silizium mit einer Temperatur von über 1600 °C in den Prozessraum eingeleitet.

In einer besonderen Fortführung der Erfindung wird das gas- oder dampfförmige Silizium durch Abdampfen von Silizium von einer SiC-Oberflache erzeugt. Das kann die Oberfläche eines SiC-Wafers bzw. von Bruchstücken davon, oder eine Silizium-Schmelze sein.

Das Abdampfen wird bei einer Temperatur von über 1400 °C vorgenommen.

Die der Erfindung zugrunde liegende Aufgabe wird weiterhin bei einer Anordnung zum Tempern von SiC-Wafern dadurch gelöst, dass mit dem Prozessraum zur Aufnahme von mindestens einem Wafer eine Quelle für zumindest dampf- bzw. gasförmiges Silizium zur Erhöhung des Si-Partialdrucks verbunden ist.

Die Quelle für dampf- bzw. gasförmiges Silizium ist ein Verdampfer, dem ein Trägergas, eine Gasströmung über einer Si-Schmelze erzeugend, zuführbar ist, wobei der Verdampfer über eine Rohrleitung mit dem Prozessraum verbunden, oder in diesem angeordnet ist.

In Fortführung der Erfindung ist der Verdampfer eine Box, die aus Graphite, Siliziumcarbid, oder aus mit Silizium beschichtetem Graphite oder Tantalcarbide, Keramik, Saphir oder Molybdän besteht.

Die Quelle für dampf- bzw. gasförmiges Silizium im Verdampfer ist ein Siliziumwafer oder Siliziumbruch, oder eine Silizium-Schmelze im Verdampfer.

Schließlich ist der Verdampfer unterhalb des Prozessraumes im Temperofen angeordnet und zwar in einem Temperaturbereich von 1450 - 1700 °C des Temperofens. Dadurch benötigt der Verdampfer keine eigene Heizung.

In einer Variante der Erfindung ist der Verdampfer im Prozessraum unterhalb der Wafer angeordnet.

Als Trägergas können Edelgase, wie Argon oder Helium, eingesetzt werden, oder auch H₂. Voraussetzung ist hier eine von Sauerstoff freie Atmosphäre.

Die Temperatur im Verdampfer liegt bei 1450 - 1700 °C und im Prozessraum zwischen 1600 und 1900 °C.

Gemäß der Erfindung wird aus einem Verdampfer (Bubbler) ein Si-Dampf oder Si-Trägergasgemisch in den Prozessraum eingebracht.

Die Erfindung soll nachfolgend an einem Ausführungsbeispiel näher erläutert werden. In den zugehörigen Zeichnungen zeigen:
- Fig. 1:: eine schematische Darstellung einer erfindungsge- mäßen Anordnung zum Tempern von SiC-Wafern mit ei- nem Verdampfer unterhalb des Prozessraumes; und
- Fig. 2:: eine vergrößerte Darstellung eines im Prozessraum unten angeordneten des Verdampfers.

Der Verdampfer 4 besteht aus einer Box unterhalb des Prozessraumes 2 eines Temperofens 1 unterhalb eines Hochtemperaturbereiches bis 2000 °C), in dem die SiC-Wafer 3 getempert werden. Der Verdampfer 4 besteht entweder aus Graphite, Siliziumgraphite oder aus einem mit SiC beschichtetem Graphite. Der Verdampfer kann auch aus Materialien wie Tantalcarbide, Saphir, Keramik oder Molybdän gefertigt werden. Im Verdampfer befinden sich ein Siliziumwafer 3.1 als Si-Dampfquelle, oder auch Siliziumbruchstücke, wobei letztere zu bevorzugen sind.

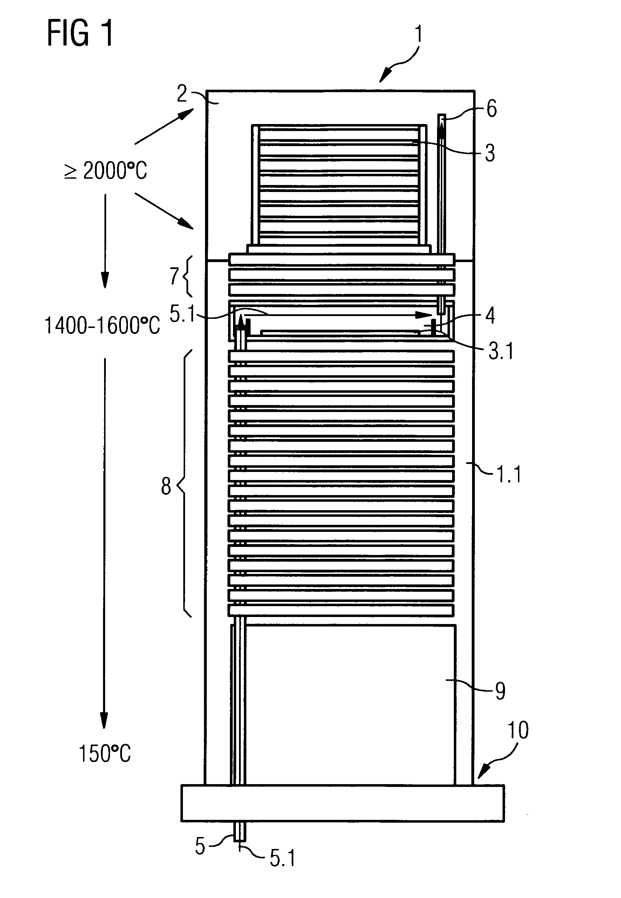

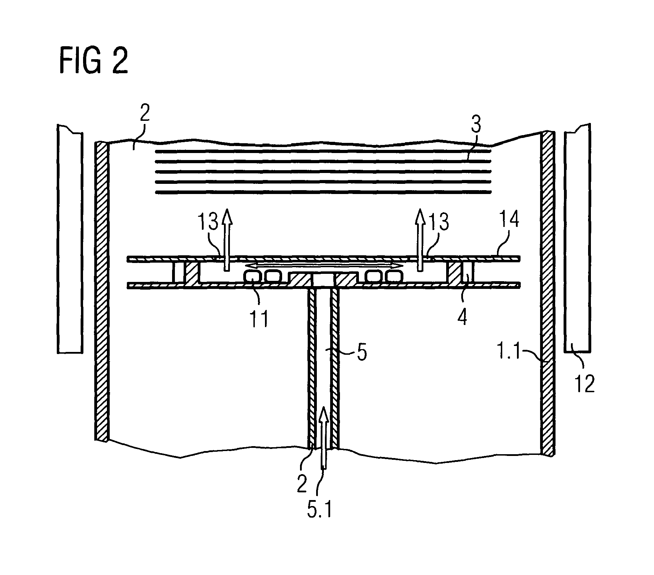

Der erforderliche Temperaturbereich im Verdampfer liegt zwischen 1400 - 1600 °C, zumindest über der Schmelztemperatur von Silizium (1414 °C). Diese Temperatur wird unterhalb einer Wärmeisolation 7 und oberhalb von Isolierschichten 8 unterhalb des Prozessraumes 2 erreicht (Fig. 1). Damit entsteht aus dem im Verdampfer befindlichen SiC-Wafer 3 (Fig. 1) flüssiges Silizium 11 (Fig. 2). Durch oder über diese Si-Schmelze kann nun ein Trägergas geleitet (gebubbelt) werden kann. Das Trägergas 5.1 kann auch über die Oberfläche der Schmelze geleitet werden. Als Trägergas 5.1 kommen Ar, H₂, He usw. in Betracht.

Beim Zuführen des Trägergases 5.1 aus einem Gasvorrat über die Verbindungsleitung 5 und dem nachfolgenden Leiten des Trägergases 5.1 durch die Schmelze wird verdampftes Silizium mitgenommen und das Gasgemisch, z.B. Ar-Si, kann dann über ein Rohr 6 (Fig. 1) zu den im Prozessraum 2 befindlichen SiC-Wafern 3 geleitet werden und dort den nötigen Si-Partialdruck erzeugen, der ein Abdampfen von Silizium von den zu tempernden SiC-Wafern 3 verhindert. Die Verbindungsleitung 5 und das Rohr 6 können aus SiC, Keramik, Saphir, Molybdän oder Graphit gefertigt werden.

Wesentlich ist, dass durch die Erfindung auf vollkommen ungefährliche Weise der nötige Si-Partialdruck im Prozessraum 2 aufgebaut werden kann, und zwar einfach durch die Geschwindigkeit und Menge der Zuführung des Trägergases.

Die zugehörige Fig. 1 zeigt einen Temperofen 1 mit einer Wandung 1.1 und einem oberen Hochtemperaturbereich bis 2000 °C, in dem die zu tempernden Wafer 3 in einem Prozessraum 2 angeordnet sind. Unterhalb des Prozessraumes 2 befindet sich der Verdampfer 4 im Temperaturbereich von über 1.400 °C mit einem oberflächlich angeschmolzenen Si-Wafer 3.1 (Fig. 1) oder geschmolzenen Si-Bruchstücken 11 (Fig. 2). Für die Zuführung des Trägergases ist eine Verbindungsleitung 5 zu einer Trägergasquelle vorgesehen und zur Zuführung eines Trägergas-Si-Gemisches zum Prozessraum 2 ein Rohr 6.

Um unterschiedliche Temperaturstufen zu realisieren, befindet sich zwischen dem Hochtemperaturbereich und dem Verdampfer 4 eine Wärmeisolation 7 (C Baffle Layer) und unterhalb des Verdampfers 4 eine weitere Wärmeisolation aus einer Mehrzahl von Isolierschichten 8 sowie einem Quarzbaffle 9. Dadurch ist es möglich, im Bodenbereich 10 des Temperofens 1 eine dauerhafte Temperatur von etwa 150 °C zu gewährleisten.

Wie aus Fig. 2 ersichtlich ist, wird der Hochtemperaturbereich einschließlich des Verdampfers 4 durch eine Heizung 12 umgeben. Im Unterschied zu Fig. 1 ist der Verdampfer 4 gemäß Fig. 2 im Prozessraum 2 unten angeordnet, so dass das verdampfte Trägergas-/Silizium-Dampf-Gemisch über Öffnungen 13 im Deckel 14 des Verdampfers 4 direkt zu den im Prozessraum 2 befindlichen Wafern 3 gelangen kann. Die Zuführung des erforderlichen Trägergases erfolgt hier ebenfalls über die Verbindungsleitung 5.

Es versteht sich, dass die Temperaturen innerhalb des Temperofens 1 durch eine Heizeinrichtung 12 erzeugt werden, welche den Prozessraum 2 sowie den Verdampfer 4 umgibt.

Gemäß dem erfindungsgemäßen Verfahren wird ein Stapel von SiC-Wafern 3.1 in einen Prozessraum 2 eines Temperofens 1 eingebracht und unter Erzeugen eines Vakuums im Prozessraum, auf eine Prozesstemperatur von 1600 - 2000 °C erhitzt, wobei gleichzeitig eine Erhöhung des Si-Partialdrucks in der Atmosphäre des Prozessraumes 2 auf einen Wert über dem Dampfdruck des im SiC-Wafer 3.1 gebundenen Siliziums über einen vorgegebenen Zeitraum bei gleich bleibender Prozesstemperatur vorgenommen wird.

Dabei kann reines gas- oder dampfförmiges Silizium, oder ein Gemisch aus einem Trägergas und gas- oder dampfförmigem Silizium in den Prozessraum 2 eingeleitet werden. Als Trägergase kommen Argon, Helium oder auch H₂ in Betracht.

Das Trägergas wird an den geschmolzenen Bruchstücken 11 (über 1414 °C) vorbeigeleitet und nimmt dabei Silizium in Dampfform mit in den Prozessraum 2 (versinnbildlicht durch die Pfeile in Fig. 1, 2).

Durch die Anordnung des Verdampfers 4 im Prozessraum 2 (Fig. 2), oder unterhalb des Prozessraumes (Fig. 1) sowie durch die Geschwindigkeit des Trägergases und dessen Menge kann der Silizuim-Partialdruck im Prozessraum eingestellt werden.

Um eine gleich bleibenden Prozesstemperatur zu gewährleisten, wird das gas- oder dampfförmige Silizium oder das Gemisch aus dem Trägergas und dem gas- oder dampfförmigen Silizium mit einer Temperatur von über 1600 °C in den Prozessraum 2 eingeleitet.

### Verfahren und Anordnung zum Tempern von SiC-Wafern

### Bezugszeichenliste

- 1: Temperofen
- 1.1: Wandung
- 2: Prozessraum
- 3: zu tempernde Wafer
- 3.1: SiC-Wafer
- 4: Verdampfer
- 5: Verbindungsleitung
- 6: Rohr
- 7: Wärmeisolation
- 8: Isolierschichten
- 9: Quarzbaffle
- 10: Bodenbereich
- 11: verflüssigte Si-Bruchstücke
- 12: Heizung
- 13: Öffnung
- 14: Deckel

## Patentansprüche

1. Verfahren zum Tempern von SiC-Wafern im Hochtemperaturbereich, mit den folgenden Schutten:
- Einbringen einer Vielzahl von SiC-Wafern (3) in einen Prozessraum (2) eines Temperofens (1) und Erzeugen eines Vakuums im Prozessraum (2),
- gleichzeitiges Erhitzen der SiC-Wafer (3) auf eine Prozesstemperatur von 1600 - 2000 °C, und
- Erhöhen des Si-Partialdrucks in der Atmosphäre des Prozessraumes (2) auf einen Wert über dem Dampfdruck des im SiC-Wafer gebundenen Siliziums über einen vorgegebenen Zeitraum bei gleich bleibender Prozesstemperatur, **dadurch gekennzeichnet, dass** ein Gemisch aus einem Trägergas und gas- oder dampfförmigem Silizium in den Prozessraum (2) eingeleitet wird.

2. Verfahren nach Anspruch 1, **dadurch gekennzeichnet, dass** als Trägergas Argon, Helium oder H₂ verwendet wird.

3. Verfahren nach Anspruch 1 oder 2, **dadurch gekennzeichnet, dass** das Gemisch aus dem Trägergas und dem gas- oder dampfförmigen Silizium mit einer Temperatur von mindestens 1450 °C in den Prozessraum (2) eingeleitet wird.

4. Verfahren nach einem der Ansprüche 1 bis 3, **dadurch gekennzeichnet, dass** das gas- oder dampfförmige Silizium durch Abdampfen von Silizium von einer SiC-Oberflache erzeugt wird.

5. Verfahren nach Anspruch 4, **dadurch gekennzeichnet, dass** das Abdampfen von Silizium von der Oberfläche eines SiC- Wafers (3.1) bzw. von Bruchstücken davon und/oder von einer Silizium-Schmelze (11) erfolgt.

6. Verfahren nach Anspruch 5, **dadurch gekennzeichnet, dass** das Abdampfen bei einer Temperatur von über 1400 °C vorgenommen wird.

7. Anordnung zum Tempern von SiC-Wafern in einem Prozessraum (2) eines Temperofens (1) im Hochtemperaturbereich, wobei mit dem Prozessraum (2) zur Aufnahme von mindestens einem Wafer (3) eine Quelle für zumindest dampf- bzw. gasförmiges Silizium zur Erhöhung des Si- Partialdrucks verbunden ist, **dadurch gekennzeichnet, dass** die Quelle für dampf- bzw. gasförmiges Silizium einen Verdampfer (4) aufweist, dem ein Trägergas, das eine Gasströmung über einer Si-Schmelze erzeugt, zuführbar ist, wobei der Verdampfer (4) über eine Rohrleitung (5) mit dem Prozessraum (2) verbunden oder in diesem angeordnet ist.

8. Anordnung nach Anspruch 7, **dadurch gekennzeichnet, dass** der Verdampfer (4) eine Box ist, die aus Graphit, Siliziumcarbid, oder mit Silizium beschichtetem Graphit oder auch Tantalcarbid, Keramik, Saphir oder Molybdän besteht.

9. Anordnung nach Anspruch 7 oder 8, **dadurch gekennzeichnet, dass** die Quelle für dampf- bzw. gasförmiges Silizium ein Siliziumwafer (3.1) oder Siliziumbruch (11) oder eine Si-Schmelze im Verdampfer (4) aufweist.

10. Anordnung nach einem der Ansprüche 7 bis 9, **dadurch gekennzeichnet, dass** der Verdampfer (4) unterhalb des Prozessraumes (2) im Temperofen (1) angeordnet ist.

11. Anordnung nach einem der Ansprüche 7 bis 9, **dadurch gekennzeichnet, dass** der Verdampfer (4) im Prozessraum (2) unterhalb der Wafer (3) angeordnet ist.

12. Anordnung nach Anspruch 11, **dadurch gekennzeichnet, dass** der Verdampfer (4) in einem Temperaturbereich von 1450 - 1700 °C des Temperofens (1) angeordnet ist.

13. Anordnung nach einem der Ansprüche 7 bis 12, **dadurch gekennzeichnet, dass** als Trägergas Edelgase wie Argon, Helium oder H₂ eingesetzt werden.

14. Anordnung nach einem der Ansprüche 7 bis 13, **dadurch gekennzeichnet, dass** die Temperatur im Verdampfer zwischen 1450 und 1600 °C einstellbar ist und/oder die Temperatur im Prozessraum zwischen 1600 und 1900 °C einstellbar ist.

15. Verwendung von SiC-Wafern, Siliziumscheiben oder Bruchstücken davon zur Durchführung des Verfahrens nach den Ansprüche 1 bis 6, und/oder in einer Vorrichtung nach den Ansprüchen 7 bis 14.

## Claims

1. Method for annealing SiC-wafers in a high-temperature range, said method comprising the steps of:
- introducing a plurality of SiC-wafers (3) in a process chamber (2) of an annealing oven (1) and generating a vacuum in the process chamber (2), simultaneously heating the SiC-wafers (3) to a process temperature of 1600 - 2000°C, and
- increasing the Si partial pressure in the atmosphere of the process chamber (2) to a value above the vapor pressure of the silicon bound in the SiC-wafer for a predetermined period of time at a constant process temperature, **characterized in that** a mixture of a carrier gas and silicon in gas or vapor form is introduced into the process chamber (2).

2. The method of claim 1, **characterized in that** argon helium or H₂ is used as the carrier gas.

3. The method of claims 1 or 2, **characterized in that** the mixture of a carrier gas and the silicon in gas or vapor form is introduced into the process chamber (2) at a temperature of at least 1450°C.

4. The method of one of claims 1 to 3, **characterized in that** the silicon in gas or vapor form is generated by vaporizing silicon from a SiC-surface.

5. The method of claim 4, **characterized by** vaporizing silicon from the surface of a SiC-wafer (3.1), from fragments thereof and/or from molten silicon (11).

6. The method of claim 5, **characterized in that** the vaporization is carried out at a temperature of above 1400°C.

7. Apparatus for annealing SiC-wafers in a process chamber (2) of an annealing oven (1) in a high-temperature range, wherein the process chamber (2) for receiving at least one wafer (3) is connected to a source of at least silicon in vapor or gas form for increasing the silicon partial pressure, **characterized in that** the source for silicon in vapor or gas form comprises a vaporizer (4), to which a carrier gas that generates a flow of gas over molten silicon may be fed, and wherein the vaporizer (4) is connected to the process chamber (2) via a conduit (5) or is arranged therein.

8. The apparatus of claim 7, **characterized in that** the vaporizer (4) is a box, consisting of graphite, silicon-carbide or silicon coated graphite or tantalum carbide, ceramics, sapphire or molybdenum.

9. The apparatus according to claim 7 or 8, **characterized in that** the source of silicon in vapor or gas form is a silicon wafer (3.1) or silicon fragments (11) or molten silicon in the vaporizer (4).

10. The apparatus according to one of claims 7 to 9, **characterized in that** the vaporizer (4) is arranged below the process chamber (2) within the annealing oven (1).

11. The apparatus according to one of claims 7 to 9, **characterized in that** the vaporizer (4) is arranged in the process chamber (2) below the wafer (3).

12. The apparatus according to claim 11, **characterized in that** the vaporizer (4) is arranged in a temperature range of 1450 - 1700°C of the annealing oven (1).

13. The apparatus according to one of claims 7 to 12, **characterized in that** noble gases such as argon, helium or H₂ are used a carrier gas.

14. The apparatus according to one of claims 7 to 13, **characterized in that** the temperature in the vaporizer is adjustable between 1450 and 1600°C, and/or the temperature in the process chamber is adjustable between 1600 and 1900°C.

15. Use of SiC-wafers, silicon disks or fragments thereof for carrying out the method of claims 1 to 6, and/or in an apparatus of claims 7 to 14.

## Revendications

1. Procédé de recuit de tranches de SiC dans une plage de haute température, ce procédé comprenant les étapes suivantes :
- introduire une pluralité de tranches de SiC (3) dans une chambre de traitement (2) d'un four de recuit (1) et produire un vide dans la chambre de traitement (2), et chauffer simultanément les tranches de SiC (3) à une température de traitement de 1600 à 2000°C, et
- augmenter la pression partielle de Si dans l'atmosphère de la chambre de traitement (2) à une valeur supérieure à la pression de vapeur du silicium lié dans les tranches de SiC pendant une durée prédéterminée à une température de traitement constante, **caractérisé en ce qu'**un mélange de gaz porteur et de silicium sous forme de gaz ou de vapeur est introduit dans la chambre de traitement (2).

2. Procédé selon la revendication 1, **caractérisé en ce que** de l'argon, de l'hélium ou de l'hydrogène est utilisé comme gaz porteur.

3. Procédé selon la revendication 1 ou 2, **caractérisé en ce que** le mélange de gaz porteur et de silicium sous forme de gaz ou de vapeur est introduit dans la chambre de traitement (2) à une température d'au moins 1450°C.

4. Procédé selon l'une quelconque des revendications 1 à 3, **caractérisé en ce que** le silicium sous forme de gaz ou de vapeur est produit en vaporisant du silicium à partir d'une surface de SiC.

5. Procédé selon la revendication 4, **caractérisé par** la vaporisation du silicium à partir de la surface d'une tranche de SiC (3.1), à partir de fragments de celle-ci, et/ou de silicium fondu (11).

6. Procédé selon la revendication 5, **caractérisé en ce que** la vaporisation est effectuée à une température supérieure à 1400°C.

7. Dispositif de recuit de tranches de SiC dans une chambre de traitement (2) d'un four de recuit (1) dans une plage de haute température, dans lequel la chambre de traitement (2), adaptée à recevoir au moins une tranche (3), est reliée à une source comprenant au moins du silicium sous forme de vapeur ou de gaz pour augmenter la pression partielle de silicium, **caractérisé en ce que** la source de silicium sous forme de vapeur ou de gaz comprend un moyen de vaporisation (4) auquel un gaz porteur qui produit un flux de gaz sur du silicium fondu peut être fourni, et dans lequel le moyen de vaporisation (4) est relié à la chambre de traitement (2) par une conduite (5) ou est disposé à l'intérieur.

8. Dispositif selon la revendication 7, **caractérisé en ce que** le moyen de vaporisation (4) est une boîte comprenant du graphite, du carbure de silicium ou du silicium revêtu de graphite ou du carbure de tantale, une céramique, du saphir ou du molybdène.

9. Dispositif selon la revendication 7 ou 8, **caractérisé en ce que** la source de silicium sous forme de vapeur ou de gaz est une tranche de silicium (3.1), ou des fragments de silicium (11), ou du silicium fondu dans le moyen de vaporisation (4).

10. Dispositif selon l'une quelconque des revendications 7 à 9, **caractérisé en ce que** le moyen de vaporisation (4) est disposé sous la chambre de traitement (2) dans le four de recuit (1).

11. Dispositif selon l'une quelconque des revendications 7 à 9, **caractérisé en ce que** le moyen de vaporisation (4) est disposé dans la chambre de traitement (2) sous la tranche (3).

12. Dispositif selon la revendication 11, **caractérisé en ce que** le moyen de vaporisation (4) est mis dans une plage de température de 1450° à 1700°C du four de recuit (1).

13. Dispositif selon l'une quelconque des revendications 7 à 12, **caractérisé en ce que** des gaz nobles tels que l'argon, l'hélium ou l'hydrogène sont utilisés comme gaz porteurs.

14. Dispositif selon l'une quelconque des revendications 7 à 13, **caractérisé en ce que** température dans le moyen de vaporisation est réglable entre 1450 et 1600°C et/ou la température dans la chambre de traitement est réglable entre 1600 et 1900°C.

15. Utilisation de tranches de SiC, de disques de silicium, ou de fragments de ceux-ci pour mettre en oeuvre un procédé selon les revendications 1 à 6 et/ou dans un appareil selon les revendications 7 à 14.
